Europäisches Patentamt

European Patent Office

Office européen des brevets

(11) Publication number : **0 522 524 B1**

(12) **EUROPEAN PATENT SPECIFICATION**

(45) Date of publication of patent specification :
12.01.94 Bulletin 94/02

(51) Int. Cl.⁵ : **H03H 11/48, H01P 5/18**

(21) Application number : **92111573.9**

(22) Date of filing : **08.07.92**

(54) **Microwave hybrid directional coupler with concentrated constants and quadrature outputs.**

(30) Priority : **11.07.91 IT MI911924**

(43) Date of publication of application :
**13.01.93 Bulletin 93/02**

(45) Publication of the grant of the patent :
**12.01.94 Bulletin 94/02**

(84) Designated Contracting States :
**DE ES FR GB GR IT SE**

(56) References cited :
**DE-A- 1 962 648**
**DE-B- 1 166 855**
**FR-A- 2 301 109**
**PATENT ABSTRACTS OF JAPAN vol. 010, no.**
**075 (E-390)25 March 1986**

(73) Proprietor : **SIEMENS TELECOMUNICAZIONI**
**S.P.A.**
**SS. 11 Padana Superiore Km. 158**
**I-20060 Cassina de Pecchi (Milano) (IT)**

(72) Inventor : **Marconi, Franco**
**Via Tosi, 3**
**I-20052 Monza (MI) (IT)**

## Description

The present invention relates to a microwave hybrid directional coupler with concentrated constants and quadrature outputs.

The requirement to integrate as much as possible in ever smaller spaces calls for the study and development of new passive electrical networks as alternatives for those by now established.

The technology employed to provide directional couplers with quadrature outputs depends on the range of frequencies in which they operate.

Microstrip couplers operating in a range of frequencies above 3GHz are provided, in accordance with the known art, by distributed-constant networks which allow achievement of branch-line or tandem or Lange or slot-line couplers.

Couplers operating in the VHF range, between 30 and 300MHz, are provided in accordance with the known art by the use of discrete components such as mutually coupled capacitors and inductances wrapped on toroidal or ferrite nuclei (see e.g. DE-B-11 66 855).

If it is desired to provide couplers operating in a range of frequencies between 0.8GHz and 3GHz the use of distributed-constant networks conflicts however with modern concepts of high integration.

On the other hand the use of mutually coupled capacitors and inductors would be unthinkable because capacitance and inductance would take on values not found in ordinary components. In addition the ferrite toroids available in trade would display unacceptable loss factors.

The document DE-A-19 62 648 discloses a "branch-line" hybrid circuit using interdigitated capacitors for even-odd compensation.

The purpose of the present invention is to provide a directional coupler with concentrated constants and quadrature outputs which would be usable in the microwave range between approximately 0.8GHz and 3GHz.

Another purpose is to provide a coupler of the above type which could be made with thin film in accordance with modern concepts of advanced integration without displaying any coating, welding of the "bonding" type or by-passes and/or 'air bridges'.

In accordance with the present invention said purposes are achieved by means of a microwave hybrid directional coupler with concentrated constants and quadrature outputs comprising a pair of inductances placed between a first pair of gates and a second pair of gates, a first and a second group of capacitances connected to said first and second pairs of gates respectively and characterized in that said pair of inductances is made of thin film and each group of capacitances consists of an interdigitated capacitor of thin film having a terminal strip connected to a gate of a respective first or second pair of gates, another terminal strip connected to the other gate of said pair of gates and two pluralities of finger elements connected to respective terminal strips of said interdigitated capacitor and mutually alternated.

The characteristics of the present invention will be further clarified by a practical form of embodiment thereof illustrated by way of nonlimiting example in the annexed drawings wherein:-

FIG. 1 shows the electrical diagram of a directional coupler,

FIG. 2 shows a plan view of a directional coupler like that of FIG. 1 provided in accordance with the present invention, and

FIG. 3 shows a cross section along plane III-III of FIG. 2.

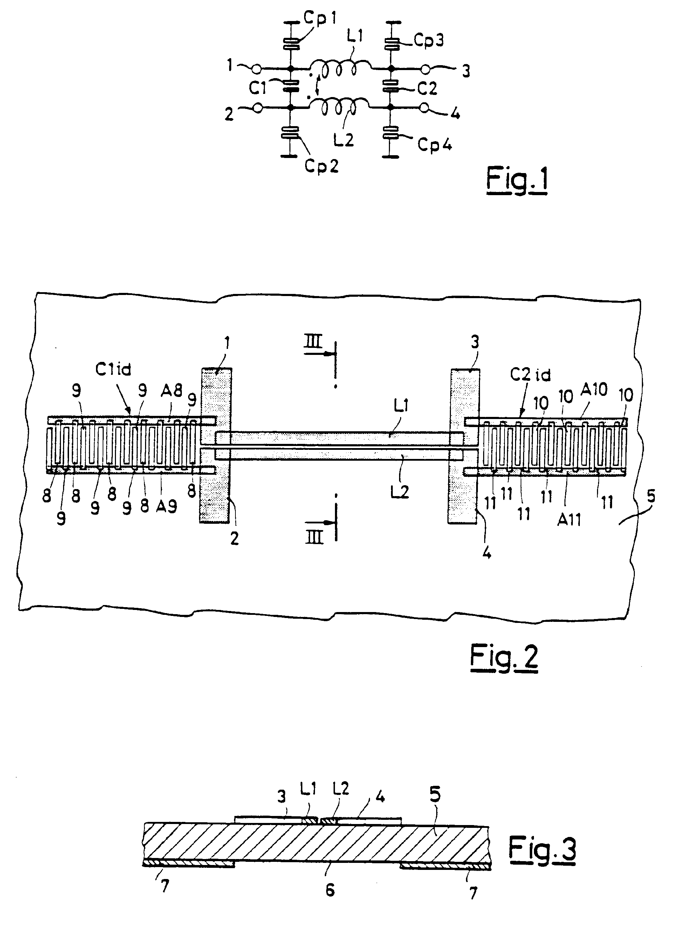

With reference to FIG. 1 there is illustrated therein the equivalent circuit diagram of a directional coupler operating in the 2GHz range which descends from a transposition with discrete parameters of a directional coupler used in the microwave range such as for example that in accordance with the present invention.

The coupler appears as a network in which are represented the electric and magnetic couplings.

A directional coupler is in general terms a four-gate device, i.e. an input gate, which can be any one of the four, two output gates and a gate decoupled from the input. Once the input gate is selected the others are defined automatically.

In the nonlimiting example described here the directional coupler comprises an input gate 1, a gate 4 decoupled from the input and a pair of output gates 2, 3 in mutual quadrature, i.e. in a 90° phase relationship. Between the gates 1, 2 and the gates 3, 4 is placed a pair of inductances L1, L2 with mutual inductance M. The 90° phase relation between the output gates 2, 3 is valid for any coupling value.

To gates 1, 2 are connected respective terminals of a capacitance C1 which are connected in turn to ground through respective capacitances $Cp1$ and $Cp2$ which are equal.

To the gates 3, 4 are connected respective terminals of a capacitance C2 (equal to the capacitance C1) which are in turn connected to ground through respective capacitances $Cp3$ and $Cp4$ which are equal.

Theoretically it is possible to determine the value of each element of the network of FIG. 1 in any frequency range by using the formulas given below. Subsequently the production phase will show up feasibility problems.

The formulas useful in calculating the network are summarized here, specifying that these are well known formulas for which there is an ample bibliography.

We have
$$Cp1 = Cp2 = Cp3 = Cp4 = 1/(Z1 * wo)$$
$$C1 = C2 = (Cp1/2) * ((Z1/Z2) - 1)$$
$$L = (Cp1/2) * (Z1^2 + Z2^2) + C1 * Z2^2$$

$$M = (Cp1/2) * (Z1^2 - Z2^2) - C1 * Z2^2$$

where

$Z1 = Ro\sqrt{((1 + K)/(1 - K))}$ = even mode characteristic impedance of the pi network element

$Z2 = Ro\sqrt{((1 - K)/(1 - K))}$ = uneven mode characteristic impedance of the pi network element

K = voltage coupling coefficient

Ro= actual characteristic impedance of the circuit in accordance with the embodiment of FIG. 1

wo = angular frequency.

It is interesting to note that in the particular case of $K=1/\sqrt{2}$ a power divider is obtained.

With reference to FIG. 1, in accordance with the present invention the array of the capacitance C1 and the associated capacitances towards ground Cp1, Cp2 and the array of the capacitance C2 and the associated capacitances towards ground Cp3, Cp4 represent respectively the equivalent circuits of interdigitated capacitors, each formed by a pair of terminal strips and a plurality of finger elements connected to respective terminal strips and alternating with each other. The capacitance C1 (or C2) represents the series-equivalent capacitance and capacitances Cp1, Cp2 (or Cp3, Cp4) the parallel equivalent capacitances of the interdigitated capacitor.

Starting from a capacitance such as for example C1, with associated capacitances towards ground, in this case Cp1, Cp2, or from a capacitance C2 with associated capacitances towards ground Cp3, Cp4, it is possible to obtain an interdigitated capacitor equivalent to the array of said capacitances C1, Cp1, Cp2; C2, Cp3, Cp4, by calculating appropriately by known formulas the geometry of all the elements making them up.

The invention aims to synthesize the geometry of an interdigitated condenser capable of providing simultaneously the correct circuit arrangement of the capacitors and their appropriate capacitance values.

With reference to FIGS. 2 and 3 and in the practical embodiment of the coupler in the form of a hybrid thin film circuit, on a ceramic substrate 5 is superimposed a pair of separate thin film microstrips designed to constitute the inductances L1 and L2. As already seen with reference to the above circuit description, these are placed between the gates 1, 2 and the gates 3, 4, which are also made by thin film deposition.

Again of thin film, to the pair of gates 1, 2 and the pair of gates 3, 4 are connected interdigitated capacitors C1id, C2id respectively corresponding to the plurality of capacitances of FIG. 1.

The interdigitated capacitor C1id comprises terminal strips A8, A9 connected to the gates 1, 2 and to which are connected respective pluralities 8, 9 of alternating finger elements.

The interdigitated capacitor C2id comprises terminal strips A10, A11 connected to the gates 3, 4 and to which are connected respective pluralities 10, 11 of finger elements alternating with each other.

The inductance L1 (or L2 equal to L1) and the mutual inductance M is calculated by applying the following formulas.

$$L1 = 0.002\,l\,\{\ln[2l/(a + b)] + 0.50049 + [(a + b)/3l]\}$$

where a and b are the dimensions of the cross section of the conductor in centimetres

$$M = 2lQ$$
$$Q = \ln\{(l/GMD) + [1 + (l^2/GMD^2)]^{1/2} - [1 + (GMD^2/l^2)]^{1/2} - (GMD/l)\}$$

where Q is a mutual inductance parameter,

GMD is the geometric average of the distance between the conductors which represent the inductances.

As shown in FIG. 3 the ceramic substrate 5 has a metal ground plane 7 underneath with a window 6 in the zone defined between the gate pairs 1, 2 and 3, 4 and including the inductances L1, L2.

This window 6 is created to increase the mutual inductance M and hence the coupling for equal length of the inductances L1, L2.

The dimensions of the ground plane 7 must be as small as possible compatibly with the requirement to not alter the coupling between the inductances L1, L2.

## Claims

1. Microwave hybrid directional coupler with concentrated constants and quadrature outputs comprising a pair of inductances (L1,L2) placed between a first pair of gates (1,2) and a second pair of gates (3,4), a first and a second group of capacitances (C1,Cp1,Cp2; C2,Cp3,Cp4) connected to said first and second pairs of gates (1,2; 3,4) respectively and characterized in that said pair of inductances (L1,L2) is made of thin film and each group of capacitances (C1,Cp1,Cp2; C2,Cp3, Cp4) consists of an interdigitated thin film capacitor (C1id,C2id) of thin film having a terminal strip (A8, A10) connected to a gate (1,3) of a respective first or second pair of gates (1,2; 3,4), another terminal strip (A9,A11) connected to the other gate (2,4) of said pair of gates (1,2; 3,4) and two pluralities (8,9; 10,11) of finger elements connected to respective terminal strips (A8,A9; A10,A11) of said interdigitated capacitor (C1id,C2id) and mutually alternated.

2. Directional coupler in accordance with claim 1 characterized in that said pair of inductances (L1,L2), said pairs of gates (1,2; 3,4) and said interdigitated capacitors (C1id,C2id) are made on a ceramic support (5) provided with an underlying metallic ground plane (7) having a window (6) opposite said inductances (L1,L2).

3. Directional coupler in accordance with claim 1 or 2 in which each group of capacitances (C1,Cp1, Cp2; C2,Cp3,Cp4) includes a first capacitance (C1,C2) connected between the two gates (1,2; 3,4) of said first or second pair of gates and a second and third capacitance (Cp1,Cp2; Cp3,Cp4) connected between a respective gate (1,2; 3,4) and ground and characterized in that said first capacitance (C1,C2) is an equivalent capacitance in series with said interdigitated capacitor (C1id, C2id) and said second and third capacitances (Cp1,Cp2; Cp3,Cp4) are equivalent capacitances in parallel with said interdigitated capacitor (C1id,C2id).

**Patentansprüche**

1. Mikrowellen-Hybridrichtkoppler mit konzentrierten Impedanzelementen und um 90° phasenvberschobenen Ausgängen, der folgendes beinhaltet: ein Paar von Induktivitäten (L1,L2), die zwischen einem ersten Paar von Gattern (1,2) und einem zweiten Paar von Gattern (3,4) angebracht sind, eine erste und zweite Gruppe von Kapazitäten (C1,Cp1,Cp2;C2, Cp3,Cp4), die jeweils mit dem ersten und zweiten Paar von Gattern (1,2;3,4) verbunden sind, dadurch gekennzeichnet, daß das genannte Paar von Induktivitäten (L1,L2) in Dünnfilmtechnik hergestellt ist und jede Gruppe von Kapazitäten (C1,Cp1,Cp2;C2,Cp3,Cp4) aus einer verschachtelten Dünnfilmkapazität (C1id, C2id) mit einem Endleiter (A8,A10) besteht, der jeweils mit dem Gatter (1,3) des betreffenden ersten oder zweiten Paars von Gattern (1,2;3,4) verbunden ist, einem weiteren mit dem anderen Gatter (2,4) des genannten Paars von Gattern (1,2;3,4) verbundenen Endleiter (A9,A11) und zwei Vielfachen (8,9;10,11) von Fingerelementen, die mit den jeweiligen Endleitern (A8,A9;A10,A11) der genannten verschachtelten und abwechselnd angeordneten Kapazitäten (C1id,C2id) verbunden sind.

2. Richtkoppler nach Anspruch 1, dadurch gekennzeichnet, daß das genannte Paar von Induktivitäten (L1,L2), das genannte Paar von Gattern (1,2;3,4) und die genannten verschachtelten Kapazitäten (C1id,C2id) auf einer keramischen Trägerplatte (5) aufgebracht sind, die auf der anderen Seite mit einer metallischen Masseschicht (7) versehen ist, die auf der den genannten Induktivitäten (L1,L2) gegenüberliegenden Fläche ein Fenster (6) aufweist.

3. Richtkoppler nach Anspruch 1 oder 2, in welchem jede Gruppe von Kapazitäten (C1,Cp1, Cp2;C2,Cp3,Cp4) eine erste Kapazität (C1,C2) einschließt, die zwischen den beiden Gattern (1,2;3,4) des genannten ersten oder zweiten Paars von Gattern angeschlossen ist, sowie eine erste und zweite Kapazität (Cp1,Cp2;Cp3,Cp4), die zwischen dem entsprechenden Gatter (1,2;3,4) und der Masse angeschlossen ist und dadurch charakterisiert ist, daß die genannte erste Kapazität (C1,C2) eine equivalente Kapazität in Serie mit der genannten verschachtelten Kapazität (C1id,C2id) darstellt und die genannten zweiten und dritten Kapazitäten (Cp1,Cp2;Cp3, Cp4) equivalente Kapazitäten sind, parallel zu der genannten verschachtelten Kapazität (C1id,C2id).

**Revendications**

1. Coupleur directif hybride à micro-onde, à constantes localisées et sorties en quadrature comprenant une paire d'inductances (L1,L2) placées entre une première paire de portes (1,2) et une deuxième paire de portes (3,4), un premier et un deuxième groupes de condensateurs (C1,Cp1,Cp2;C2,Cp3,Cp4) connectés auxdites première et deuxième paires de portes (1,2; 3,4) respectivement et caractérisé en ce que ladite paire d'inductances (L1,L2) est faite en couches minces et chaque groupe de condensateurs (C1,Cp1,Cp2;C2,Cp3,Cp4) consiste en un condensateur lamellaire en couches minces (C1id, C2id) ayant une réglette à broches (A8, A10) connectée à une porte (1,3) d'une première ou deuxième paire respective de portes (1,2; 3,4), une autre réglette à broches (A9,A11) connectée à l'autre porte (2,4) de ladite paire de portes (1,2; 3,4) et deux pluralités (8,9; 10,11) d'éléments contacts connectés aux réglettes à broches respectives (A8,A9; A10,A11) dudit condensateur lamellaire (C1id,C2id) et mutuellement alternés.

2. Coupleur directif selon la revendication 1, caractérisé en ce que ladite paire d'inductances (L1,L2), lesdites paires de portes (1,2; 3,4) et lesdits condensateurs lamellaires (C1id,C2id) sont réalisés sur un support en céramique (5) doté d'un plan de masse sousjacent (7) ayant une fenêtre (6) en face desdites inductances (L1,L2).

3. Coupleur directif selon la revendication 1 ou 2, dans lequel chaque groupe de condensateurs (C1,Cp1,Cp2;C2,Cp3,Cp4) comprend un premier condensateur (C1,C2) connecté entre les deux portes (1,2: 3,4) de ladite première ou deuxième paire de portes et un deuxième et troisième condensateur (Cp1,Cp2;Cp3,Cp4) connectés entre une porte respective (1,2; 3,4) et la masse et caractérisé en ce que ledit premier condensateur (C1,C2) est un condensateur équivalent en série avec ledit condensateur lamellaire (C1id, C2id) et lesdits deuxième ou troisième condensateurs (Cp1,Cp2; Cp3,Cp4) sont des condensateurs équivalents en parallèle avec ledit condensateur lamellaire (C1id,C2id).

Fig.1

Fig.2

Fig.3